Europäisches Patentamt

European Patent Office

Office européen des brevets

(11) Veröffentlichungsnummer: **0 381 051**
**A1**

# EUROPÄISCHE PATENTANMELDUNG

(21) Anmeldenummer: **90101478.7**

(51) Int. Cl.⁵: **C30B 15/00, C30B 29/06**

(22) Anmeldetag: **25.01.90**

(30) Priorität: **27.01.89 DE 3902452**

(43) Veröffentlichungstag der Anmeldung:
**08.08.90 Patentblatt 90/32**

(84) Benannte Vertragsstaaten:
**AT BE CH DE ES FR GB IT LI NL**

(71) Anmelder: **HELIOTRONIC Forschungs- und Entwicklungsgesellschaft für Solarzellen-Grundstoffe mbH**
**Johannes-Hess-Strasse 24**
**D-8263 Burghausen(DE)**

(72) Erfinder: **Beck, Andreas, Dr., Dr. rer. nat.**
**Wackerstrasse 22**
**D-8263 Burghausen(DE)**
Erfinder: **Geissler, Joachim, Dipl.Ing.**
**Rosen-Strasse 24**
**D-8261 Stammham(DE)**
Erfinder: **Helmreich, Dieter, Dr., Dr. rer. nat.**
**Robert-Koch-Strasse 185**
**D-8263 Burghausen(DE)**
Erfinder: **Ambros, Georg, Dipl.-Ing.**
**Wackerstrasse 30**
**D-8263 Burghausen(DE)**

(54) **Mit einer strukturierten Oberfläche versehene Substrate für das Aufwachsen von erstarrenden Schichten aus Schmelzen, insbesondere von Halbleitermaterial.**

(57) Es werden Substrate für das Aufwachsen von erstarrenden Schmelzen angegeben, die gegenüber der Substratgrundfläche erhöhte Kontaktflächen besitzen, welche so verteilt sind, daß die aufwachsende Schmelzschicht auf ihnen aufliegt und durch die Oberflächenspannung freitragend von der Grundfläche getrennt gehalten wird. Diese Substrate werden vorteilhaft für das Aufwachsen von Halbleitermaterialschichten, insbesondere auf Siliciumbasis, eingesetzt und eignen sich besonders für Verfahren zur Herstellung von Solarzellengrundmaterial, bei denen die selbsttätige Ablösung der aufgewachsenen Schicht erforderlich ist.

EP 0 381 051 A1

## Mit einer strukturierten Oberfläche versehene Substrate für das Aufwachsen von erstarrenden Schichten aus Schmelzen, insbesondere von Halbleitermaterial.

Die Erfindung betrifft mit einer strukturierten Oberfläche versehene Substrate für das Aufwachsen von erstarrenden Schichten aus Schmelzen, insbesondere von Halbleitermaterial.

Es ist bekannt, die Oberfläche von Substraten, die bei Verfahren zum Aufwachsen von Schichten aus Schmelzen verwendet werden, mit Strukturen zu versehen, um das Aufwachsverhalten und die Haftung der Schichten zu beeinflussen. Beispielsweise ist aus der EP-A-113 954 ein Verfahren zur Fertigung eines Substrates zur Verwendung bei der Herstellung von einkristallinen Dünnschichten bekannt, bei dem die Substratoberfläche mit einer Vielzahl von umgekehrten pyramidenförmigen Vertiefungen versehen wird, die dann als Keime für das aufwachsende Material dienen und zugleich auch dessen besonders feste Haftung bewirken. Bei dem Verfahren gemäß der DE-A-24 54 183 wird ein amorphes oder sehr feinkristallines Substrat mit einem periodischen Raster versehen, das die Symmetrie des zu kristallisierenden Systems besitzt und auch in seiner im Angström-Bereich liegenden Gitterperiodizität einem ganzzahligen Vielfachen von dessen Gitterkonstante entspricht. Beide Verfahren zielen somit darauf ab, auf einem billigen Substrat eine dünne Schicht hochwertigen Materials möglichst fest aufwachsen zu lassen, wodurch naturgemäß das Substrat auch nur einmal verwendet werden kann.

Insbesondere für die Herstellung von Schichten von Verbindungshalbleitern oder von Solarzellengrundmaterial, vor allem auf Basis Silicium, sind jedoch auch Verfahren bekannt geworden, bei denen die wertvolle aufgewachsene Schicht vom Substrat wieder abgetrennt wird, so daß das Substrat mehrfach verwendet werden kann. Bei der Epitaxie von Silicium kann dies beispielsweise durch eine Beschichtung der Substratoberfläche geschehen, die die Adhäsionskräfte zum kristallisierten Material verringert, wie etwa oxidische und/oder nitridische Schichtsysteme, oder durch lösliche Beschichtungen wie etwa Natriumchlorid oder -fluorid, die nach erfolgter Epitaxie in Wasser gelöst werden, wodurch die aufgewachsene Schicht dann leicht abgetrennt werden kann. Eine andere Möglichkeit besteht darin, durch Einstrahlung von Energie mittels Laser- oder Elektronenstrahl das Substrat an der Berührungsfläche mit dem aufgewachsenen Material anzuschmelzen, um letzteres dann abziehen zu können. Des weiteren kann die aufgewachsene Schicht auch mechanisch abgespalten werden, was beispielsweise dadurch erleichtert werden kann, daß auf das Substrat eine passivierende Deckschicht aufgetragen wird, die nur partiell Öffnungen aufweist, durch welche das aufwachsende Material sich mit dem eigentlichen Substratmaterial verbinden kann. Die Abtrennung läßt sich dann, gegebenenfalls nach Verstärkung der aufgewachsenen Schicht mit Hilfe einer geeigneten Auflage, beispielsweise mit Hilfe eines Keils vornehmen. Auch bei diesen Verfahren wird das Substrat stark beansprucht und kann deshalb nur in sehr beschränktem Maße oder nach aufwendiger Aufbereitung bzw. Regenerierung z.B. durch erneute Beschichtung wiederverwendet werden.

Aufgabe der Erfindung war es daher, Substrate der eingangs genannten Art anzugeben, die ohne Regenerierung häufig wiederverwendet werden können, die außerdem die problemlose Ablösung des aufgewachsenen Materials und eine besonders wirksame Übertragung der angestrebten Struktur vom Substrat auf die aufwachsende Schicht gewährleisten und die weiterhin ggf. den Einsatz des gleichen Ausgangsmaterials für Substrat und Schmelze gestatten.

Gelöst wird die Aufgabe durch Substrate, welche gekennzeichnet sind durch gegenüber der Substratgrundfläche erhöhte Kontaktflächen, welche so verteilt sind, daß die aufwachsende Schmelzschicht auf ihnen aufliegt und durch die Oberflächenspannung freitragend von der Grundfläche getrennt gehalten wird.

Solche erhöhten Kontaktflächen können eine oder mehrere Begrenzungsflächen von auf der Substratoberfläche erzeugten Stukturen sein, die beispielsweise die Form von trigonalen, tetragonalen oder hexagonalen Pyramiden oder Pyramidenstümpfen, von trigonalen, tetragonalen oder hexagonalen Prismen, von Würfeln, Quadern, Leisten, Stegen, Kegeln, Kegelstümpfen oder Zylindern aufweisen können und über die eigentliche, ebene Substratgrundfläche hinausragen. Die Kontaktflächen können dabei im Grenzfall punktförmig sein, nämlich wenn die Substratgrundfläche mit spitz zulaufenden Strukturen, wie etwa Pyramiden oder Kegeln, versehen ist. Bevorzugt werden jedoch Kontaktflächen vorgesehen, die parallel oder annähernd parallel zur Substratgrundfläche angeordnet sind, wie es beispielsweise bei Pyramiden- oder Kegelstümpfen wie auch bei prismen-, würfel- oder quaderförmigen Erhöhungen in der Substratgrundfläche der Fall ist.

Unter Substratgrundfläche ist dabei die der aufzutragenden Schmelzschicht zugewandte geometrisch ideale Oberfläche des Substrates zu verstehen, d.h. die durch die Außenmaße des Substrates bestimmte ebene Begrenzungsfläche des geometrisch vollkommen gedachten Körpers, im Falle eines quadratischen Substrates also beispielsweise eine ebene quadratische Fläche. Das Niveau der Substratgrundfläche bezüglich der Kontaktflächen entspricht dem Niveau der Basisflächen der Strukturen. Mithin kann also beim Erzeugen der Strukturen eine gegenüber der ursprünglichen, unstrukturierten Oberfläche des Substrates tieferliegende Substratgrundfläche geschaffen werden, nämlich wenn die Strukturen durch abtragende Bearbeitung aus der ursprünglichen Oberfläche des Substrates herausgearbeitet werden. In den Fällen, in denen die Strukturen auf das Substrat zusätzlich aufgebracht werden, entspricht hingegen oftmals zumindest in erster Näherung die ursprüngliche Oberfläche des Substrates der Substratgrundfläche.

Vorteilhaft wird die Größe der Kontaktflächen so gewählt, daß ihre Projektion auf die Grundfläche des Substrates höchstens ca. 10 %, vorzugsweise bis zu ca. 2 % und günstig bis zu etwa 1.5 % dieser Fläche entspricht. Die Angabe möglicher Untergrenzen ist in diesem Zusammenhang nicht möglich, da die Kontaktflächen im Grenzfall punktförmig sein und daher gegen 0 gehen können. Es wurde gefunden, daß in diesen Bereichen sowohl eine ausreichende Abführung der Kristallisationswärme in das Substrat gewährleistet ist, während andererseits die Ablösung der aufgewachsenen Schicht keine Schwierigkeiten bereitet. Die angegebenen Werte haben sich in Verbindung mit Schmelzen bewährt, deren Oberflächenspannung im Bereich von etwa 450 bis 1000 dyn/cm liegt; grundsätzlich ist es jedoch nicht ausgeschlossen, bei Schmelzen mit geringer Oberflächenspannung auch größere Kontaktflächen vorzusehen, insbesondere wenn die Schmelzen eine hohe Dichte aufweisen.

Zweckmäßig entsprechen die Abmessungen der der Schmelze zugewandten Substratfläche annähernd oder genau den für die aufzuwachsende Schicht vorgesehenen Maßen, wobei gegebenenfalls auch nicht bedeckte Bereiche vorgesehen werden können. Beispielsweise werden in der Regel für die Erzeugung von rechteckigen oder quadratischen Scheiben auch rechteckige oder quadratische Substratkörper eingesetzt. Die Dicke des Substrates soll einerseits eine ausreichende mechanische Stabilität, andererseits auch eine genügend große Wärmekapazität gewährleisten, um den beim Auftragen der Schmelzschicht, bei deren Erstarren und bei der Ablösung der entstandenen Scheibe auftretenden mechanischen und thermischen Wechselwirkungen standhalten zu können. In den meisten Fällen wird für das Substrat nur ein Material verwendet; grundsätzlich sind jedoch auch kombinierte Substratkörper nicht ausgeschlossen, bei denen auf einen Basiskörper, beispielsweise aus Metall oder Graphit, ein anderes, oberflächenstrukturiertes Material aufgebracht wird, auf das dann beim eigentlichen Aufwachsprozeß die Schmelzschicht aufgetragen wird. Diese Variante empfiehlt sich vor allem in den Fällen, in denen das oberflächenstrukturierte Material wertvoll ist.

Obwohl die Substrate auch bei Prozessen mit unterschiedlichem Substrat- und Schmelzenmaterial eingesetzt werden können, lassen sich besonders gute Ergebnisse erzielen, wenn das Substrat oder zumindest seine strukturierte Oberfläche aus dem selben Material bestehen wie die Schmelze, aus der dann die aufwachsende Schicht aufgetragen wird. Solche Substrate werden vor allem bei Materialien eingesetzt, bei denen es auf hohe Reinheit und Kristallqualität ankommt, also in erster Linie Halbleitermaterialien, z.B. Verbindungshalbleiter wie Galliumarsenid, Galliumphosphid, Indiumphosphid oder Kupfer-Indium-Selenid, oder Elementhalbleiter wie Germanium oder insbesondere Silicium. Die Substratkörper aus beispielsweise Silicium können dabei aus monokristallinem, aber auch aus grob- oder feinkörnigem polykristallinem Material gefertigt sein, wobei in der Regel dann auf die aufwachsende Schicht die Kristallstruktur des Substrates entweder vollständig oder aber zumindest in großen Bezirken übertragen wird. Dieser Effekt ist insbesondere von Bedeutung bei der Herstellung von Solarzellengrundmaterial auf Basis von sogenanntem multikristallinem Silicium, welches aus größeren einkristallinen Bezirken mit einer kristallographischen Vorzugsorientierung aufgebaut ist.

Die Verteilung der erhöhten Kontaktflächen über die Substratgrundfläche stellt sicher, daß die aufwachsende Schmelzschicht auf ihnen aufliegt und freitragend von der Grundfläche getrennt gehalten wird. Sie wird im wesentlichen nach Maßgabe von Eigenschaften des für das Aufwachsen vorgesehenen Materials wie insbesondere Oberflächenspannung und Dichte sowie nach verschiedenen Parametern des Aufwachsprozesses ausgewählt. Allgemein ist der maximal mögliche Abstand zwischen benachbarten Kontaktflächen um so geringer, je kleiner die Oberflächenspannung und/oder je größer die Dichte des aufwachsenden Materials ist. Ebenso wird mit abnehmender Oberflächenspannung und/oder steigender Dichte der Schmelze eine um so größere Höhe der Kontaktflächen gegenüber der Substratgrundfläche erforderlich. Daneben spielt auch die Relativgeschwindigkeit zwischen Substrat und Schmelze, mit der die aufwachsende Schicht aufgetragen wird, eine Rolle; größere Relativgeschwindigkeiten bedingen dabei in der Regel kleinere Entfernungen benachbarter Kontaktflächen voneinander und/oder größere Höhen. Die geeigneten Parameter lassen sich gegebenenfalls an Hand von Vorversuchen ermitteln, anpassen oder optimieren. Nachstehend sind diese Zusammenhänge stellvertretend am Beispiel Silicium erörtert; sie lassen sich jedoch analog auf die anderen geeigneten Materialien übertragen, so daß die folgenden Ausführungen nicht im Sinne einer Beschränkung zu sehen sind.

Als günstig hat es sich insbesondere im Hinblick auf die geometrische Qualität der aufgewachsenen Schichten erwiesen, die Kontaktflächen in gleicher Größe, gleicher Entfernung voneinander und gleicher

3

Höhe gegenüber der Substratgrundfläche vorzusehen, wobei im allgemeinen Differenzen bis zu etwa 10% des jeweiligen Wertes keine nachteilige Wirkung aufweisen. Dies ist jedoch nicht zwingend vorgeschrieben, und es ist grundsätzlich nicht ausgeschlossen, Substrate mit unterschiedlich großen, hohen und verschieden weit voneinander entfernten Kontaktflächen einzusetzen.

Der Abstand benachbarter Kontaktflächen voneinander, durch den jeweils die von dem Schmelzmeniskus der aufgetragenen Schmelzschicht freitragend zu überspannende Strecke vorgegeben ist, hat als oberen Grenzwert den Wert, bei dem die zwischen den Auflageflächen durchhängende Schmelze gerade noch nicht in Kontakt mit der Substratgrundfläche kommt. Dabei ist auch die Höhe der Kontaktflächen gegenüber dieser Fläche zu berücksichtigen, da naturgemäß die Ausbauchung der der Substratgrundfläche zugewandten Schmelzenoberfläche ohne Kontakt zu dieser um so stärker ausgeprägt sein kann, je größer die Höhendifferenz zwischen Kontakt- und Grundfläche ist. Der zulässige Grenzwert ist dann überschritten, wenn die Oberflächenspannung nicht mehr ausreicht, um die aufliegende Schmelzenmenge frei zu tragen, so daß schließlich die Substratgrundfläche mit der ihr zugewandten Oberfläche der Schmelzschicht in Kontakt kommt. Richtwerte für mögliche Obergrenzen der Abstände und Höhen der Kontaktflächen lassen sich durch die Bedingung abschätzen, daß der Krümmungsradius des sich zwischen zwei Auflagepunkten ausbildenden Schmelzmeniskus nicht größer sein darf als die Höhe dieser Auflagepunkte gegenüber der Substratgrundfläche, und daß die Entfernung der Auflagepunkte voneinander nicht größer sein darf als der zweifache Krümmungsradius. Für Substrate für das Aufwachsen von geschmolzenem Silicium, dessen Oberflächenspannung etwa 720 dyn/cm und dessen Dichte etwa 2.49 g/cm$^3$ beträgt, haben sich Werte dieser beiden Kenngrößen im Bereich von 10 bis 1000 $\mu$m, bevorzugt 50 bis 500 $\mu$m bewährt. Als günstig hat es sich insbesondere erwiesen, die Substrate mit Strukturen zu versehen, bei denen die Parameter Höhe und Abstand der Kontaktflächen größenordnungsmäßig in etwa gleich sind, wobei vorteilhaft die Höhe dem 0.5 bis 2-fachen des Abstandswertes entspricht. Es wurde gefunden, daß solcherart gestaltete Substratoberflächen ein günstiges Aufwachs- und Ablöseverhalten gewährleisten.

Schon aus Gründen der leichteren Herstellung werden die Substrate bevorzugt mit solchen Strukturen versehen, die ebene Begrenzungsflächen aufweisen, also beispielsweise rechteckigen oder pyramidenförmigen Erhöhungen. Solche Formen wie etwa Stege, Quader oder Pyramiden haben neben der leichten Formgebung auch den Vorteil, daß sie beim Aufwachsen und Ablösen der Schicht geringen mechanischen Verschleiß erfahren.

Für die Präparation der Substratoberfläche, d.h. für die Erzeugung der gewünschten Strukturen, können grundsätzlich diejenigen Methoden eingesetzt werden, die die gezielte formende Beeinflussung von Festkörperoberflächen in dem erforderlichen feinen und genauen Maßstab gestatten. Bewährt haben sich insbesondere mechanische Methoden wie Sägen oder Schleifen, bei denen mittels geeignet dimensionierter Werkzeuge oder Werkzeuggruppen die Substratoberfläche kontrolliert abgetragen wird. Auf diese Weise kann z.B. in der ursprünglich glatten Oberfläche ein System von einander kreuzenden Gräben definierter Tiefe und definierten Abstandes erzeugt werden, aus denen wie Inseln als Reste der ursprünglichen Oberfläche die die Kontaktflächen tragenden Erhöhungen herausragen. Die mechanischen Methoden können bei Substraten aus mono- oder polykristallinem Silicium mit geläppter, geätzter oder polierter Oberfläche eingesetzt werden; die Bearbeitung kann beispielsweise mittels diamantbesetzter Werkzeuge erfolgen.

Insbesondere bei monokristallinen Substraten kommt auch die Behandlung der Oberfläche mit geeigneten Strukturätzen in Frage, durch die diese anisotrop angegriffen und abgetragen wird. Solche Ätzlösungen sind bekannt; als Beispiel seien alkalische Lösungen auf Basis von Natrium- oder Kaliumhydroxid genannt, durch welche sich z.B. in monokristallinen Siliciumoberflächen mit (100)-Orientierung pyramidenartige Strukturen erzeugen lassen. Allerdings ist die mit solchen Ätzmethoden erreichbare geometrische Präzision meist geringer als bei den vorher genannten mechanischen Verfahren.

Grundsätzlich möglich ist auch der Einsatz von anderen bekannten Methoden zur Erzeugung von Oberflächenstrukturen wie Ionenätzen oder Plasmaätzen oder auch die bei der Bauelementeherstellung häufig verwendeten photolithographischen Verfahren. Diese Verfahren haben zwar den Vorteil großer Genauigkeit, sind aber mit hohem apparativem Aufwand verbunden. Auch das Herausarbeiten der erforderlichen Höhe der Kontaktflächen gegenüber der Substratgrundfläche kann in manchen Fällen schwierig sein.

Neben diesen abtragenden Methoden kommen jedoch auch solche in Frage, bei denen die Strukturen durch Aufbringen von zusätzlichem Material auf der vorgegebenen Substratgrundfläche aufgebaut werden. Als Beispiele sind etwa die Gasphasenabscheidung auf der mit geeigneten Masken versehenen Substratoberfläche oder die Methode des Sputterns zu nennen.

Es ist im Rahmen der Erfindung auch nicht ausgeschlossen, die Substrate bzw. ganz oder teilweise die Bereiche zwischen den Kontaktflächen oder die Kontaktflächen selbst mit einer Beschichtung zu versehen, um das Ablösen der aufgewachsenen Schicht zu erleichtern oder Reaktionen der Substratoberfläche mit der Arbeitsatmosphäre zu verhindern. Solche Beschichtungen lassen sich beispielsweise durch Niederschlagen aus der Gasphase, durch Aufsprühen oder Aufgießen oder durch chemische Reaktion wie etwa Oxidieren, Nitridieren oder Carbidisieren aufbringen. Ein mögliches Beispiel ist das Aufbringen einer Schicht aus Siliciumcarbid auf ein Substrat aus Silicium.

Die erfindungsgemäßen Substrate werden mit besonderem Vorteil in Verfahren eingesetzt, bei denen durch eine Relativbewegung zwischen der jeweils vorgelegten Schmelze und dem Substrat die erstarrende Schicht aufgebracht wird. Eine Möglichkeit liegt beispielsweise darin, daß bei ruhendem Substrat die Schmelze in der gewünschten Schichtdicke aufgegossen oder aufgestrichen wird. Günstiger sind jedoch die Methoden, bei denen eines oder mehrere bewegte Substrate mit einer ruhenden Schmelze in Kontakt gebracht werden und dabei sich mit einer dünnen Schmelzschicht überziehen, wobei im allgemeinen durch Regelung der Substratgeschwindigkeit auch die Schichtdicke gesteuert werden kann. Ein Beispiel sind Verfahren, bei denen das Substrat oder eine Substratgruppe bzw. ein aus mehreren Einzelsubstraten zusammengesetztes Band zumindest mit seiner strukturierten Oberfläche in die Schmelze eintaucht und, gegebenenfalls nach einer translatorischen Bewegung im Oberflächenbereich der Schmelze, diese mit der aufwachsenden Schmelzschicht beladen wieder verläßt. Ein weiterer möglicher Einsatzbereich sind solche Verfahren, bei denen die Substrate als bewegte Unter lage dienen, auf welche dann, gegebenenfalls unter Zuhilfenahme eines die Phasengrenzfläche geometrisch vorgebenden Formkörpers, die Schmelze aufgetragen wird. In der Regel wird dabei die Unterlage horizontal, manchmal aber auch in einer von der Horizontalen abweichenden Richtung bewegt. Weiterhin können die Substrate auch bei Verfahren zum Einsatz kommen, bei denen die Schmelze auf rotierende Trommeln aufgegossen oder aufgetragen wird, erstarrt, und sich dann ablöst und als dünne Folie abgehoben und entnommen werden kann. Dabei können die Trommeln mit entsprechend strukturierten Substratplatten belegt sein; es ist jedoch gleichfalls möglich, die mit der Schmelze in Kontakt kommende Trommeloberfläche selbst mit einer geeigneten Struktur zu versehen.

Mit besonderem Vorteil werden die erfindungsgemäßen Substrate bei Verfahren eingesetzt, bei denen sich die aufgetragene Schicht nach dem Erstarren selbsttätig wieder vom Substrat ablöst. Ein derartiges Verfahren ist beispielsweise in der DE-A-31 32 776 bzw. der entsprechenden US-A-4,447,289 beschrieben. Dabei werden auf eine bestimmte Temperaturdifferenz zur Schmelzentemperatur eingestellte Substrate mit hoher Geschwindigkeit an einem Schmelzmeniskus vorbeibewegt und ziehen dabei eine Schmelzschicht mit sich, die erstarrt und sich dann wieder ablöst. Nach diesem Verfahren lassen sich grob- bis einkristalline Folien oder Platten aus Halbleitermaterial und insbesondere Silicium erhalten, welche sich vor allem als Solarzellengrundmaterial eignen. Durch die Verwendung der erfindungsgemäß oberflächenstrukturierten Substrate bei diesem Verfahren werden besonders gute Ergebnisse in Bezug auf die selbsttätige Abtrennung des kristallisierten Materials und die Wiederverwendbarkeit des Substrates erzielt. Ebenso zeichnen sich die erhaltenen Folien oder Platten durch eine hohe, mit herkömmlichen Substraten nicht erreichbare Kristallperfektion aus. Daraus gefertigte Bauelemente, vor allem diejenigen auf Siliciumbasis, zeigen beispielsweise gegenüber auf herkömmlichen Substraten gewachsenem Material eine deutlich verbesserte Diffusionslänge der Minoritätsträger, was auf eine bessere Kristallqualität zurückzuführen ist. Außerdem ist wegen der gegenüber herkömmlichen Substraten geringeren Größe der Kontaktfläche die Gefahr der Übertragung von kontaminierenden Verunreinigungen deutlich geringer.

Nachstehend werden die erfindungsgemäßen Substrate sowie mögliche Verwendungen an Hand von Ausführungsbeispielen näher erläutert.

Beispiel 1:

Quadratische Platten aus monokristallinem Silicium (Kantenlänge ca. 5 cm, Dicke ca. 0.7 cm, (100)- bzw. (111)-Orientierung, polierte Oberfläche) wurden durch abtragende Bearbeitung mit einer strukturierten Oberfläche versehen. Zu diesem Zweck wurden in die polierte Oberfläche mit Hilfe einer rotierenden Walze, die im Abstand von ca. 720 μm diamantbesetzte Schleifkanten mit V - förmigem Querschnitt aufwies, zunächst parallel zu einer Kante und danach im rechten Winkel hierzu zueinander parallele und jeweils gleichen Abstand voneinander aufweisende linienförmige Ausnehmungen eingeschliffen. Bei einem Teil der Platten wurden versetzt dazu in weiteren analogen Bearbeitungsschritten jeweils zwischen den bereits erzeugten Strukturen zusätzliche Ausnehmungen eingeschliffen, so daß schließlich eine Vielzahl von mit Oberflächenstrukturen verschiedener Periodizität versehenen Substraten zur Verfügung stand. Die Bearbeitungstiefe war bei der Mehrzahl der Platten auf ca. 100 μm, bei den restlichen auf ca. 50 μm eingestellt.

Die erhaltenen Oberflächenstrukturen hatten jeweils die Form von quadratischen Pyramiden bzw.

Pyramidenstümpfen mit quadratischer Deckfläche, die voneinander durch V - förmige Einschnitte getrennt waren. Die Abstände der einzelnen Strukturelemente voneinander, d.h. die jeweils kürzesten Translationslängen, um ein Strukturelement mit seinem Nachbarelement möglichst weitgehend zur Deckung zu bringen, waren innerhalb der Platten jeweils gleich, variierten jedoch von Platte zu Platte zwischen 90 und 720 μm, wobei die genauen Werte in der Tabelle angegeben sind. Die Höhe der Kontaktflächen gegenüber der Substratgrundfläche entsprach im wesentlichen der Bearbeitungstiefe und lag damit bei ca. 100 bzw. ca. 50 μm. Eine an Hand von Flächenausschnitten durchgeführte Abschätzung des Größenverhältnisses der Kontaktflächen zur Substratgrundfläche (ca. 25 cm²) ergab einen maximalen Wert von etwa 2%, typisch jedoch deutlich darunter liegende Werte.

Die erhaltenen Substrate wurden visuell und teilweise mittels Mikroskop auf etwaige Mängel in der Oberflächenstruktur untersucht und diejenigen ausgesondert, bei denen der Anteil mechanischer Zerstörungen, Fehlstellen oder Beschädigungen der Pyramidenstruktur einen bestimmten Grenzwert überschritt. Dabei wurden alle Substrate zugelassen, bei denen mindestens 90% der Strukturelemente sich als einwandfrei erwiesen.

Platten jeweils gleicher kristallographischer Orientierung und Oberflächenstruktur wurden nun zu Substratgruppen zusammengefaßt und in einem Verfahren gemäß der DE-A-31 32 776 bzw. der entsprechenden US-A-4,447,289, welches auch unter der Bezeichnung RAFT-Verfahren bekannt geworden ist, zur Herstellung von Siliciumscheiben als Grundmaterial für Solarzellen eingesetzt. Die auf bestimmte Temperaturen eingestellten Substratgruppen wurden dabei mit verschiedenen Ziehgeschwindigkeiten an einem Meniskus aus geschmolzenem Silicium (Schmelzentemperatur ca. 1420 °C) vorbeibewegt und überzogen sich mit einer dünnen Schmelzschicht, die danach erstarrte und nach dem selbsttätigen Ablösen zur Weiterverarbeitung zur Verfügung stand. Die wichtigsten Verfahrensparameter sind in der Tabelle angegeben.

Die erhaltenen Scheiben hatten Dicken zwischen 80 und 200 μm und lagen damit in einem für die Solarzellenherstellung besonders gut geeigneten, jedoch mit konventionellen Sägeverfahren schwer zugänglichen Dickenbereich. Sie besaßen jeweils die Orientierung des Substrates, auf welches sie aufgewachsen waren, also (100) oder (111). Eine Untersuchung der Kristallqualität mit Hilfe von kombinierten Schliff-Ätzmethoden zeigte, daß das Produkt frei von Korngrenzen war.

Eine Überprüfung der Diffusionslängen der Minoritätsträger über die Solarzellenkennlinie des Materials nach einer zusätzlichen Wasserstoffpassivierung ergab Werte von ca. 90 bis 100 μm. Bei in ansonsten gleicher Weise, aber unter Verwendung von unstrukturierten Substraten hergestellten Schichten aus Silicium betrugen diese Werte nur 30 bis 50 μm. Aus dem mit den erfindungsgemäßen Substraten hergestellten Material lassen sich also Solarzellen mit höheren Wirkungsgraden erhalten.

Die Substrate konnten problemlos wiederholt eingesetzt werden und zeigten stets eine einwandfreie selbsttätige Ablösung der aufgewachsenen Schicht.

Nach mehrmaligem Einsatz wurde die Oberflächenstruktur der Substrate im Mikroskop untersucht. Dabei zeigte sich, daß sich viele der ursprünglich ebenen quadratischen Kontaktflächen verändert hatten; sie besaßen nunmehr die Form von pyramiden- bis kegelförmigen Spitzen. Diese Formänderung ist vermutlich auf die beim Aufwachsen und Ablösen der Schmelzschicht auftretenden Wechselwirkungen zwischen Substrat und kristallisierendem Material zurückzuführen. Eine derartige Oberflächenstruktur ist erfahrungsgemäß genau so wirksam wie die anfänglich vorliegende Substratstruktur, solange nicht die zwischen den einzelnen Kontaktflächen sich bei häufigem Einsatz ausbildenden Höhen- und Abstandsunterschiede den zulässigen Grenzwert überschreiten. Gegebenenfalls kann auch durch eine Oberflächenbehandlung wie beispielsweise Ätzen oder mechanisches Nachbearbeiten, z.B. Nachschleifen ein Substrat wieder regeneriert werden. Auf diese Weise können die erf indungsgemäßen Substrate nahezu unbeschränkt wiederverwendet werden.

Beispiel 2:

Analog dem in Beispiel 1 beschriebenen Bearbeitungsverfahren wurde eine quadratische Platte aus monokristallinem Silicium (Kantenlänge 10 cm, Dicke ca. 0.7 cm, (111)-Orientierung, polierte Oberfläche) mit einer strukturierten Oberfläche versehen, wobei jedoch die Gruppen untereinander paralleler linienförmiger Ausnehmungen zueinander einen Winkel von 60° aufwiesen. Die Bearbeitungstiefe betrug ca. 100 μm, und die entstandene Oberflächenstruktur hatte quasi hexagonale Symmetrie, wobei die in Richtung der quasi hexagonalen Achsen gemessenen Abstände der Kontaktflächen ca. 180 μm betrugen. Die Oberflä-chenstrukturen hatten die Form von Pyramiden bis Pyramidenstümpfen mit parallelogrammartigen Basisflächen. Eine visuelle Abschätzung des Verhältnisses der Projektion der Kontaktflächen zur Substratgrundfläche ergab einen Wert von ca. 0.3%.

Wird das solcherart erhaltene Substrat auf der Unterseite eines absenkbaren und zur Abführung der Kristallisationswärme kühlbaren Stempels befestigt, so kann es durch Absenken des Stempels mit der Oberfläche von in einer flachen Kokille vorgelegtem schmelzflüssigem Silicium, dessen Menge der für die vorgesehene Scheibengröße erforderlichen Siliciummenge entspricht, in Kontakt gebracht werden. Bei einer Substrattemperatur von ca. 1000° C und einer Schmelzentemperatur von etwa 1420° C wächst innerhalb einer Verweilzeit von etwa 50 bis 500 msec Silicium als Schicht auf das Substrat auf, bleibt zunächst beim erneuten Hochfahren des Stempels bis zum vollständigen Erstarren haften, beginnt sich dann selbsttätig abzulösen und kann mit Hilfe einer Greifvorrichtung entnommen werden. Der Stempel kann danach wieder abgesenkt und die in einer weiteren Kokille vorgelegte Schmelzenmenge zum Aufwachsen und Erstarren gebracht werden, worauf nach dem Hochfahren des Stempels die sich ablösende Scheibe entnommen werden kann. Dieser Vorgang kann mit weiteren mit schmelzflüssigem Silicium beschickten Kokillen taktweise wiederholt werden, wobei wegen der kurzen Kristallisationsphase Taktzeiten im Sekundenbereich möglich sind.

Die erhaltenen Siliciumscheiben besitzen (111)-Orientierung, sind frei von Korngrenzen und haben Dicken im für die Solarzellenherstellung besonders interessanten Bereich von 80 bis 200 μm.

Tabelle:

| Substrat- und Prozeßparameter beim Aufwachsvorgang | | | |
|---|---|---|---|
| Abstand der Kontaktflächen [μm] | Höhe der Kontaktflächen [μm] | Substrattemperatur [°C] | Ziehgeschwindigkeit [mm/s] |
| 720 | 100 | 970 | 25 |
| 360 | 100 | 970 | 50 |
| 240 | 100 | 970 | 100 |
| 180 | 100 | 970 | 100 |
| 90 | 100 | 970 | 100 |
| 180 | 100 | 970 | 50 |
| 180 | 100 | 970 | 100 |
| 90 | 100 | 970 | 200 |
| 60 | 100 | 970 | 300 |
| 180 | 100 | 970 | 100 |
| 180 | 50 | 970 | 100 |
| 180 | 100 | 920 | 100 |
| 180 | 100 | 970 | 100 |
| 180 | 100 | 1020 | 100 |

**Ansprüche**

1. Mit einer strukturierten Oberfläche versehene Substrate für das Aufwachsen von erstarrenden Schichten aus Schmelzen, insbesondere von Halbleitermaterial, gekennzeichnet durch gegenüber der Grundfläche des Substrates erhöhte Kontaktflächen, welche so verteilt sind, daß die aufwachsende Schmelzschicht auf ihnen aufliegt und durch die Oberflächenspannung freitragend von der Grundfläche getrennt gehalten wird.

2. Substrat nach Anspruch 1, dadurch gekennzeichnet, daß die Höhe benachbarter Kontaktflächen gegenüber der Grundfläche des Substrates größer ist als der Krümmungsradius des Schmelzmeniskus zwischen diesen Flächen.

3. Substrat nach den Ansprüchen 1 oder 2, dadurch gekennzeichnet, daß der Abstand benachbarter Kontaktflächen voneinander kleiner ist als der zweifache Krümmungsradius des Schmelzmeniskus zwischen diesen Flächen.

4. Substrat nach einem oder mehreren der Ansprüche 1 bis 3, dadurch gekennzeichnet, daß der Abstand benachbarter Kontaktflächen 10 bis 1000 $\mu$m beträgt.

5. Substrat nach einem oder mehreren der Ansprüche 1 bis 4, dadurch gekennzeichnet, daß die Kontaktflächen periodisch angeordnet sind.

6. Substrat nach einem oder mehreren der Ansprüche 1 bis 5, dadurch gekennzeichnet, daß die Projektion der Kontaktflächen auf die Grundfläche des Substrates höchstens 10% der Grundfläche entspricht.

7. Substrat nach einem oder mehreren der Ansprüche 1 bis 6, dadurch gekennzeichnet, daß es aus dem selben Material wie die Schmelze besteht.

8. Substrat nach einem oder mehreren der Ansprüche 1 bis 7, dadurch gekennzeichnet, daß es aus Silicium besteht.

9. Verwendung von Substraten nach einem oder mehreren der Ansprüche 1 bis 8 in Verfahren, bei denen die erstarrende Schicht durch eine Relativbewegung zwischen Schmelze und Substrat aufgebracht wird.

10. Verwendung von Substraten nach einem oder mehreren der Ansprüche 1 bis 8 in Verfahren, bei denen die erstarrende Schicht sich nach dem Erstarren selbsttätig vom Substrat ablöst.

11. Verwendung von Substraten nach einem oder mehreren der Ansprüche 1 bis 8 zur Herstellung von Solarzellengrundmaterial, insbesondere auf Siliciumbasis.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| Y | JOURNAL OF CRYSTAL GROWTH, Band 82, Nrs. 1-2, 1. März 1987, Seiten 127-133, Elsevier Science Publishers B.V. (North-Holland Physics Publishing Division), Amsterdam, NL, PROCEEDINGS OF THE 1ST INT. SYMP. ON SHAPED CRYSTAL GROWTH, Budapest, HU, 22.-25. Juli 1986; A. BECK et al.: "Shaped crystal growth of silicon foils by raft" * Seite 128 * --- | 1-3,5,7 -11 | C 30 B 15/00<br>C 30 B 29/06 |
| Y | GB-A-2 034 217 (SWISS ALUMINIUM LTD) * Figuren 1,2; Seite 2, Zeilen 24-70; Ansprüche 1,7,9 * --- | 1-3,5,7 -11 | |
| P,X | EP-A-0 338 914 (COMMISSARIAT A L'ENERGIE ATOMIQUE) * Ansprüche 1-8; Figuren 5,3a,b * --- | 1 | |
| A | EP-A-0 165 449 (BAYER AG) --- | | |
| X | FR-A-2 344 332 (METALS RESEARCH LTD) * Seite 1, Zeilen 1-5; Seite 7, Zeilen 2-33; Figuren 1,7-10 * --- | 1-3,5,8 ,9 | RECHERCHIERTE SACHGEBIETE (Int. Cl.5)<br><br>C 30 B<br>B 22 D |
| A,D | EP-A-0 072 565 (HELIOTRONIC mbH) --- | | |
| A,D | DE-A-2 454 183 (FRAUNHOFER-GESELLSCHAFT ZUR FÖRDERUNG DER ANGEWANDTEN FORSCHUNG eV) --- | | |
| A | EP-A-0 113 954 (HAMAKAWA) ----- | | |

Der vorliegende Recherchenbericht wurde für alle Patentansprüche erstellt

| Recherchenort | Abschlußdatum der Recherche | Prüfer |
|---|---|---|
| DEN HAAG | 04-05-1990 | COOK S.D. |